(19) **Europäisches Patentamt**

**European Patent Office**

**Office européen des brevets**

(11) **EP 1 014 580 B1**

(12) **EUROPÄISCHE PATENTSCHRIFT**

(45) Veröffentlichungstag und Bekanntmachung des Hinweises auf die Patenterteilung:
**30.03.2005   Patentblatt 2005/13**

(51) Int Cl.$^7$: **H03K 5/19**, G01R 25/00

(21) Anmeldenummer: **99121193.9**

(22) Anmeldetag: **23.10.1999**

(54) **Verfahren zum Messen der zeitlichen Verzögerung zwischen zwei periodischen Pulssignalen mit der gleichen Frequenz**

Method for measuring the delay between two periodic pulse signals of the same frequency

Procédé de mesure du retard entre deux signaux d'impulsions périodiques de même fréquence

(84) Benannte Vertragsstaaten:
**DE FR GB**

(30) Priorität: **21.12.1998   DE 19859082**

(43) Veröffentlichungstag der Anmeldung:
**28.06.2000   Patentblatt 2000/26**

(73) Patentinhaber: **Valeo Schalter und Sensoren GmbH**
**74321 Bietigheim-Bissingen (DE)**

(72) Erfinder:
• **Reiche, Martin**
**53639 Königswinter (DE)**
• **Kostorz, Wolfgang**
**74321 Bietigheim-Bissingen (DE)**

(74) Vertreter: **Dreiss, Fuhlendorf, Steimle & Becker Patentanwälte,**
**Postfach 10 37 62**
**70032 Stuttgart (DE)**

(56) Entgegenhaltungen:
**DE-A- 4 419 472          US-A- 4 282 482**

**Beschreibung**

Die vorliegende Erfindung betrifft ein Verfahren zum Messen der zeitlichen Verzögerung zwischen einem ersten periodischen Pulssignal und einem zweiten periodischen Pulssignal, das die gleiche Frequenz aufweist wie das erste Pulssignal.

Die Erfindung betrifft außerdem ein Verfahren zum Messen des Abstands zwischen zwei Objekten mittels eines Sensors, der an einem der Objekte angeordnet ist, wobei

- durch den Sensor ein erstes periodisches Pulssignal ausgelöst und in Richtung auf das andere Objekt ausgesendet wird,
- das von dem anderen Objekt reflektierte erste Pulssignal, das um eine von dem Abstand der beiden Objekte abhängige Laufzeit verzögert ist, von dem Sensor empfangen wird,
- durch den Sensor ein um eine variable zeitliche Verzögerung verzögertes zweites periodisches Pulssignal ausgelöst wird,
- die variable zeitliche Verzögerung des zweiten Pulssignals variiert wird, und
- die variable zeitliche Verzögerung bestimmt wird, die gleich der Laufzeit des empfangenen reflektierten ersten Pulssignals ist.

Die Erfindung betrifft des weiteren eine Vorrichtung zum Messen der zeitlichen Verzögerung zwischen einem ersten periodischen Pulssignal und einem zweiten periodischen Pulssignal, das die gleiche Frequenz aufweist wie das erste Pulssignal.

Schließlich betrifft die vorliegende Erfindung einen Sensor zum Messen des Abstands zwischen zwei Objekten, wobei der Sensor an einem der Objekte angeordnet ist und aufweist:

- erste Mittel zum Auslösen und zum Aussenden eines ersten periodischen Pulssignals in Richtung auf das andere Objekt,
- zweite Mittel zum Empfangen des von dem anderen Objekt reflektierten ersten Pulssignals, das um eine von dem Abstand der beiden Objekte abhängige Laufzeit verzögert ist,
- dritte Mittel zum Auslösen eines um eine variable zeitliche Verzögerung verzögerten zweiten periodischen Pulssignals,
- vierte Mittel zum Variieren der variablen zeitlichen Verzögerung des zweiten Pulssignals, und
- fünfte Mittel zum Bestimmen der eingestellten variablen zeitlichen Verzögerung, die gleich der Laufzeit des empfangenen reflektierten ersten Pulssignals ist.

Das Messen der zeitlichen Verzögerung zwischen zwei periodischen Pulssignalen mit der gleichen Frequenz findet in einer Vielzahl von unterschiedlichen Bereichen Anwendung. Ein bevorzugter Einsatzbereich ist die Abstandsmessung zwischen zwei Objekten. Die Objekte können bspw. als Kraftfahrzeuge ausgebildet sein. Es ist bekannt, den Abstand zwischen zwei hintereinander fahrenden Kraftfahrzeugen durch Regelung der Geschwindigkeit des hinteren Kraftfahrzeugs konstant zu halten. Dazu weist das hintere Kraftfahrzeug in seinem vorderen Bereich einen Sensor der eingangs genannten Art auf, mit dem der Abstand zu dem vorausfahrenden Kraftfahrzeug gemessen werden kann.

Zum Messen des Abstands zwischen zwei Objekten mit einem Sensor, der an dem einem der Objekte angeordnet ist, werden üblicherweise Sensoren eingesetzt, die die Laufzeit eines ersten periodischen Pulssignals von seiner Aussendung durch den Sensor über die Reflexion an dem anderen Objekt bis zu dem Empfang durch den Sensor bestimmen. Die Laufzeit des ersten Pulssignals ergibt sich aus dem doppelten Abstand der beiden Objekte dividiert durch die Ausbreitungsgeschwindigkeit des ersten Pulssignals. Aus der Laufzeit des empfangenen ersten Pulssignals kann somit der Abstand zwischen den beiden Objekten ermittelt werden. Auf dieser Grundlage arbeiten bspw. Ultraschallsensoren und Pulsradar-Sensoren.

Die Ausbreitungsgeschwindigkeit der Pulssignale beträgt bei Ultraschallsensoren (als Pulssignale werden Schallwellen ausgesandt) in etwa Schallgeschwindigkeit (in Luft etwa 330 m/s) und bei Pulsradar-Sensoren (als Pulssignale werden elektromagnetische Wellen ausgesandt) Lichtgeschwindigkeit (in Luft etwa $300 \cdot 10^6$ m/s). Insbesondere bei Pulsradar-Sensoren liegen die zu bestimmenden Laufzeiten bei der Annahme eines maximalen Meßbereichs von wenigen Metern im Nanosekundenbereich. Bei einem angenommenen Meßbereich von bspw. 10 m ergibt sich eine Laufzeit des Signals von etwa $66 \cdot 10^{-9}$ s = 66 ns. Aufgrund dieser äußerst kurzen Laufzeiten der Pulssignale können solche Pulslaufzeiten nicht direkt gemessen werden, indem bspw. ein Zeitgeber beim Aussenden des Signals mit START und beim Empfang des reflektierten Signals mit STOP gesetzt wird. Vielmehr finden zum Bestimmen der Pulslaufzeiten indirekte vergleichende Verfahren Anwendung (vgl. DE-A 44 19 472).

Die vergleichenden Verfahren arbeiten bspw. nach dem folgenden Prinzip: Ein Pulswiederholgenerator des Sensors löst das erste periodische Pulssignal aus. Das erste Pulssignal benötigt von seiner Aussendung durch den Sensor über die Reflexion an dem anderen Objekt bis zu dem Empfang durch den Sensor eine bestimmte Laufzeit. Zur Bestimmung der Laufzeit löst der Sensor, bzw. der Pulswiederholgenerator, ein zweites periodisches Pulssignal aus, das die gleiche Frequenz wie das erste Pulssignal aufweist und das um eine variable zeitliche Verzögerung gegenüber dem ersten Pulssignal über ein sensorinternes variables Totzeitglied verzögert ist. Die Ansteuerung des variablen Totzeitglieds erfolgt dabei über eine relativ langsam variierende Sweepspannung.

Sowohl das empfangene erste Pulssignal als auch das verzögerte zweite Pulssignal wird einem Mischer zugeführt, der genau dann ein maximales Ausgangssignal liefert, wenn die Laufzeit des empfangenen ersten Pulssignals gleich groß ist wie die durch das variable Totzeitglied eingestellte Verzögerung des zweiten Pulssignals.

Theoretisch würde es ausreichen, die interne Verzögerung mit einer reinen Steuerung durch einen Zeitbereich zu sweepen, der dem Meßbereich des Sensors entspricht. Wenn der Sensor bspw. einen Meßbereich von 10 m bis 1000 m hat, könnte die Verzögerung in dem variablen Totzeitglied in einen Zeitbereich von 66 ns bis 6,6 μs durch kontinuierliches Verändern der Sweepspannung variiert werden.

Eine reine Steuerung hat jedoch den Nachteil, daß sie einen Drift der Totzeiteigenschaften des Totzeitglieds über die Sensorbetriebstemperatur und das Betriebsalter des Sensors sowie eine Bauteilstreuung des Sensors nicht berücksichtigen kann. Da das Totzeitglied in der Regel analog aufgebaut ist, läßt sich ein Drift der Totzeiteigenschaften kaum vermeiden. Aus diesem Grund muß von einer reinen Steuerung auf eine Regelung übergegangen werden. Der Meßvorgang verläuft dann folgendermaßen: Die Sweepspannung durchläuft kontinuierlich und wiederholt, z. B. als Sägezahnsignal, einen bestimmten Bereich, so daß die interne Verzögerung des Totzeitglieds z. B. von 0 ns bis 40 ns (das entspricht einem Meßbereich von etwa 0 m bis 6 m) über die Zeit variiert wird. Wenn während dieses Vorgangs reflektierte erste Pulssignale an den Mitteln zum Empfangen eintreffen, die eine externe Laufzeit aufweisen, die der momentan eingestellten internen Verzögerung entspricht, so resultiert dies in einem detektierbaren Anstieg des Ausgangssignals am Mischer. Es wird nun geprüft, welche interne Verzögerung zu diesem Zeitpunkt des Maximums am Mischerausgang eingestellt ist. Diese Verzögerung kann einerseits aus der Sweepspannung selbst ermittelt werden, wobei man nicht bekannte Meßfehler (aufgrund von Alterung und Streuung) bei der Umsetzung der Sweepspannung auf die interne Verzögerung in Kauf nehmen muß. Die andere Möglichkeit besteht in einer Messung der Pulsflanken des ersten und des zweiten Pulssignals und damit der eingestellten Verzögerung. Es findet also keine Regelung im eigentlichen Sinne statt, sondern vielmehr eine Messung des momentan eingestellten Wertes der Verzögerung. Eine Art Regelung findet erst in einem zweiten Schritt statt, wenn die Auswerteeinheit (z. B. ein Mikrocontroller) durch die Messungen "lernt", welche Sweepspannung welcher Verzögerung entspricht und dies in den nachfolgenden Durchläufen berücksichtigt. Voraussetzung dieses Lernprozesses, der den alters- und temperaturbedingten Drift der internen Verzögerungseinheit kompensiert, ist die Einführung eines Zeitmeßglieds. Der Gegenstand dieser Patentanmeldung betrifft ein solches Zeitmeßglied.

Für eine solche Regelung muß also die zeitliche Verzögerung zwischen dem ausgesandten ersten Pulssignal und dem zweiten intern verzögerten Pulssignal ermittelt werden. Nach dem Stand der Technik wird als die zeitliche Verögerung einfach die Einstellung des Totzeitglieds übernommen. Dabei kann jedoch, wie oben bereits erläutert, ein Drift der Totzeiteigenschaften des Totzeitglieds über die Sensorbetriebstemperatur und über das Betriebsalter des Sensors sowie eine Bauteilstreuung des Totzeitglieds nicht berücksichtigt werden. Aus diesem Grund kann die nach dem Stand der Technik ermittelte zeitliche Verzögerung relativ stark von der tatsächlichen Verzögerung abweichen, was unter Umständen zu einem recht ungenauen Meßergebnis des Abstands zwischen den beiden Objekten führen kann.

Eine Aufgabe der vorliegenden Erfindung besteht somit darin, ein Verfahren zum Messen der zeitlichen Verzögerung zwischen zwei periodischen Pulssignalen mit der gleichen Frequenz der eingangs genannten Art dahingehend auszugestalten und weiterzubilden, daß die zeitliche Verzögerung zwischen den zwei periodischen Pulssignalen möglichst genau ermittelt werden kann.

Zur Lösung dieser Aufgabe schlägt die Erfindung ausgehend von dem Verfahren zum Messen der zeitlichen Verzögerung zwischen zwei periodischen Pulssignalen der eingangs genannten Art ein Verfahren vor, das gekennzeichnet ist durch die nachfolgenden Schritte:

- Erzeugen eines periodischen Diagnosesignals mit der halben Frequenz des ersten Pulssignals, dessen Tastverhältnis ein Maß für die zeitliche Verzögerung zwischen dem ersten Pulssignal und dem zweiten Pulssignal ist,
- Bestimmen des Tastverhältnisses des Diagnosesignals, und
- Bestimmen der zeitlichen Verzögerung zwischen dem ersten Pulssignal und dem zweiten Pulssignal aus dem Tastverhältnis des Diagnosesignals.

Erfindungsgemäß ist erkannt worden, daß der Regelkreis zur Regelung der zeitlichen Verzögerung des variablen Totzeitglieds dann besonders genau arbeitet, wenn die an dem Totzeitglied eingestellte Verzögerung möglichst genau bestimmt wird. Anstatt als Wert für die zeitliche Verzögerung einfach den an dem variablen Totzeitglied eingestellten Wert der Verzögerung zu übernehmen, wird gemäß der vorliegenden Erfindung der tatsächlich eingestellte Wert der Verzögerung gemessen.

Das periodische Diagnosesignal ist vorzugsweise als ein Rechtecksignal ausgebildet. Gemäß dem erfindungsgemäßen Verfahren wird die Verzögerung zwischen den beiden Pulssignalen aus dem Tastverhältnis des Diagnosesignals ermittelt. Das Tastverhältnis gibt das Verhältnis zwischen der Dauer der HIGH-Zustände bzw. der Dauer der LOW-Zustände einer Periode relativ zu der Periodendauer des Diagnosesignals wieder. Wenn die HIGH-Zustände und die LOW-Zustände innerhalb einer Periode gleichmäßig verteilt sind, wie bspw. bei einem gleichmäßigen Rechtecksignal, dann beträgt das Tastverhältnis in etwa 50%. Das periodische Diagnosesignal ist derart ausgebildet, daß aus dessen Tastverhältnis die zeitliche Verzögerung zwischen dem ersten Pulssignal und dem zweiten Pulssignal bestimmt werden kann.

Vorzugsweise beträgt das Tastverhältnis des Diagnosesignals ohne eine zeitliche Verzögerung zwischen dem ersten Pulssignal und dem zweiten Pulssignal etwa 50%. Des weiteren verändert sich das Tastverhältnis des Diagnosesignals vorzugsweise proportional zu einer zeitlichen Verzögerung zwischen dem ersten Pulssignal und dem zweiten Pulssignal. Demnach beträgt das Tastverhältnis etwa 100%, wenn das zweite Pulssignal relativ zu dem ersten Pulssignal um eine volle Periode des ersten Pulssignals verzögert ist.

Gemäß einer vorteilhaften Weiterbildung der vorliegenden Erfindung wird vorgeschlagen, daß das Diagnosesignal abwechselnd von einer Flanke des ersten Pulssignals und von einer Flanke des zweiten Pulssignals getriggert wird.

Gemäß einer bevorzugten Ausführungsform wird das Diagnosesignal abwechselnd von einer ansteigenden Flanke des ersten Pulssignals und von einer ansteigenden Flanke des zweiten Pulssignals getriggert. Es ist ebenfalls denkbar, daß das Diagnosesignal durch fallende Flanke der beiden Pulssignale getriggert wird.

Gemäß einer vorteilhaften Weiterbildung der Erfindung wird vorgeschlagen, daß

- ein Steuersignal mit der halben Frequenz des ersten Pulssignals erzeugt wird,
- das invertierte Steuersignal an einen ersten Steuer-Eingang eines Multiplexers geführt wird,
- das erste Pulssignal an einen ersten Signal-Eingang des Multiplexers geführt wird,
- das Steuersignal an einen zweiten Steuer-Eingang des Multiplexers geführt wird,
- das zweite Pulssignal an einen zweiten Signal-Eingang des Multiplexers geführt wird,
- der Ausgang des Multiplexers an den Takteingang eines ersten D-Flip-Flops geführt wird,
- das invertierte Steuersignal an den D-Eingang des ersten D-Flip-Flops geführt wird, und
- an einem Ausgang des ersten D-Flip-Flops das Diagnosesignal anliegt.

Gemäß dieser Weiterbildung ist der Multiplexer bspw. aus drei NAND-Gattern aufgebaut. Dann benötigt der Multiplexer nämlich zwei Steuer-Eingänge und zwei Signal-Eingänge. Ganz allgemein muß der Multiplexer mindestens einen Steuereingang, mindestens zwei Signaleingänge und mindestens einen Ausgang aufweisen.

Zum Bestimmen des Tastverhältnisses des Diagnosesignals wird gemäß einer vorteilhaften Weiterbildung der Erfindung der in dem Diagnosesignal enthaltene Gleichanteil ermittelt.

Gemäß einer bevorzugten Ausführungsform wird vorgeschlagen, daß das invertierte Diagnosesignal über einen ersten Tiefpaßfilter geführt wird. Ebenso wird vorteilhafterweise das Diagnosesignal über einen zweiten Tiefpaßfilter geführt. Die in dem Diagnosesignal enthaltenen Gleichanteile lassen sich dann besonders gut herausfiltern, wenn das Tastverhältnis des Diagnosesignals im Bereich von etwa 50% liegt, wie dies bei der vorliegenden Erfindung der Fall ist. Bei einem Tastverhältnis um die 50% treten weniger oberwellige harmonische Anteile auf als bei einem ungünstigeren Tastverhältnis, z. B. bei 10% oder 90%. Dies erleichtert die Auslegung eines das Diagnosesignal glättenden Tiefpasses, der eine geringere Güte aufweisen muß.

Eine weitere Aufgabe der vorliegenden Erfindung besteht darin, ein Verfahren zum Messen des Abstands zwischen zwei Objekten dahingehend auszugestalten und weiterzubilden, daß die Laufzeit des ersten Pulssignals von dem einen Objekt zu dem anderen Objekt und wieder zurück, insbesondere die tatsächliche Verzögerung zwischen dem ausgesandten ersten Pulssignal und dem verzögerten zweiten Pulssignal, möglichst genau ermittelt werden kann.

Zur Lösung dieser Aufgabe schlägt die Erfindung ausgehend von dem Verfahren zum Messen des Abstands zwischen zwei Objekten der eingangs genannten Art vor, daß die eingestellte variable zeitliche Verzögerung durch Messen der zeitlichen Verzögerung zwischen dem ersten Pulssignal und dem zweiten Pulssignal mittels des Verfahrens nach einem der Ansprüche 1 bis 8 bestimmt wird.

Mit dem erfindungsgemäßen Verfahren kann die Verzögerung des zweiten Pulssignals relativ zu dem ersten Pulssignal mit einer besonders hohen Genauigkeit gemessen werden.

Damit kann die Laufzeit des empfangenen ersten Pulssignals und somit auch der Abstand zwischen den beiden Objekten besonders genau bestimmt werden. Durch eine entsprechende Softwarekompensation kann des weiteren der systematische Fehler des Verzögerungsdrifts der internen Verzögerung kompensiert werden.

Die hohe Genauigkeit der Laufzeitbestimmung mittels des erfindungsgemäßen Verfahren ergibt sich daraus, daß das Meßergebnis der zeitlichen Verzögerung unabhängig von dem Drift der Totzeiteigenschaften des Totzeitglieds über die Sensorbetriebstemperatur und über das Betriebsalter des Sensors und unabhängig von einer Bauteilstreuung in dem Totzeitglied ist. Die hohe Genauigkeit der Laufzeitbestimmung macht sich insbesondere beim Messen von geringen Abständen zwischen zwei Objekten bemerkbar, da die Laufzeiten der Pulssignale dann sehr gering sind und sich Meßfehler beim Bestimmen der Verzögerung besonders stark auf die ermittelte Laufzeit und damit auf den ermittelten Abstand auswirken.

Gemäß einer vorteilhaften Weiterbildung der Erfindung wird vorgeschlagen, daß durch einen Pulswiederholgenerator des Sensors ein periodisches Pulswiederholsignal erzeugt wird und das erste Pulssignal von einer Flanke des Pulswiederholsignals ausgelöst wird. Das erste Pulssignal wird vorzugsweise von den ansteigenden Flanken des Pulswiederholsignals ausgelöst. Denkbar ist allerdings ebenfalls die Auslösung durch fallende Flanken des Pulswiederholsignals.

Gemäß einer anderen vorteilhaften Weiterbildung der Erfindung wird vorgeschlagen, daß das zweite Pulssignal von einer Flanke des um die variable zeitliche Verzögerung verzögerten Pulswiederholsignals ausgelöst wird. Das zweite Pulssignal wird vorzugsweise von den ansteigenden Flanken des verzögerten Pulswiederholsignals ausgelöst. Denkbar ist allerdings ebenfalls die Auslösung durch fallende Flanken des Pulswiederholsignals.

Vorteilhafterweise wird das invertierte Pulswiederholsignal an den Takteingang eines zweiten D-Flip-Flops geführt, liegt an einem Ausgang des zweiten D-Flip-Flops ein Steuersignal und an einem weiteren Ausgang des zweiten D-Flip-Flops das invertierte Steuersignal an, das an den D-Eingang des zweiten D-Flip-Flops geführt wird. Dadurch wird auf einfache Weise das oben erwähnte Steuersignal generiert, das den Multiplexer ansteuert. Andere Implementierungen mit anderen Flip-Flop-Typen sind allerdings ohne Einschränkung der Funktionsfähigkeit auch denkbar.

Eine weitere Aufgabe der vorliegenden Erfindung besteht darin, eine Vorrichtung zum Messen der zeitlichen Verzögerung zwischen zwei periodischen Pulssignalen der eingangs genannten Art dahingehend weiterzubilden und auszugestalten, daß die zeitliche Verzögerung zwischen den zwei periodischen Pulssignalen möglichst genau ermittelt werden kann.

Zur Lösung dieser Aufgabe schlägt die Erfindung ausgehend von der Vorrichtung zum Messen der zeitlichen Verzögerung zwischen zwei periodischen Pulssignalen der eingangs genannten Art eine Vorrichtung vor, die gekennzeichnet ist durch

- sechste Mittel zum Erzeugen eines periodischen Diagnosesignals mit der halben Frequenz des ersten Pulssignals, dessen Tastverhältnis ein Maß für die zeitliche Verzögerung zwischen dem ersten Pulssignal und dem zweiten Pulssignal ist,
- siebte Mittel zum Bestimmen des Tastverhältnisses des Diagnosesignals, und
- achte Mittel zum Bestimmen der zeitlichen Verzögerung zwischen dem ersten Pulssignal und dem zweiten Pulssignal aus dem Tastverhältnis des Diagnosesignals.

Gemäß einer vorteilhaften Weiterbildung sind die sechsten Mittel derart ausgebildet, daß das Diagnosesignal abwechselnd von einer Flanke des ersten Pulssignals und von einer Flanke des zweiten Pulssignals getriggert wird. Vorteilhafterweise sind die sechsten Mittel derart ausgebildet, daß das Diagnosesignal abwechselnd von einer ansteigenden Flanke des ersten Pulssignals und von einer ansteigenden Flanke des zweiten Pulssignals getriggert wird. Alternativ ist es ebenso denkbar, daß das Diagnosesignal abwechselnd von den abfallenden Flanken des ersten Pulssignals und des zweiten Pulssignals getriggert wird.

Gemäß einer vorteilhaften Weiterbildung der Erfindung wird vorgeschlagen, daß die sechsten Mittel aufweisen:

- Mittel zum Erzeugen eines Steuersignals mit der halben Frequenz des ersten Pulssignals,
- einen Multiplexer, an dessen erstem Eingang das invertierte Steuersignal anliegt, an dessen zweitem Eingang das erste Pulssignal anliegt, an dessen drittem Eingang das Steuersignal anliegt und an dessen viertem Eingang das zweite Pulssignal anliegt, und
- ein erstes D-Flip-Flop, an dessen Takteingang der Ausgang des Multiplexers anliegt, an dessen D-Eingang das invertierte Steuersignal anliegt und an dessen Ausgang das Diagnosesignal anliegt.

Gemäß einer anderen bevorzugten Ausführungsform wird vorgeschlagen, daß der Multiplexer drei NAND-Gatter aufweist, wobei an einem ersten Eingang des ersten NAND-Gatters das invertierte Steuersignal und an einem zweiten Eingang des ersten NAND-Gatters das erste Pulssignal angliegt, wobei an einem ersten Eingang des zweiten NAND-Gatters das Steuersignal und an einem zweiten Eingang des zweiten NAND-Gatters das zweite Pulssignal anliegt, wobei an einem ersten Eingang eines dritten NAND-Gatters der Ausgang des ersten NAND-Gatters und an einem zweiten Eingang des dritten NAND-Gatters der Ausgang des zweiten NAND-Gatters anliegt und wobei der Ausgang des dritten NAND-Gatters an dem Takteingang des ersten D-Flip-Flops anliegt. Ein derart aus drei NAND-Gattern aufgebauter Multiplexer kann besonders preiswert realisiert werden. Auf den Einsatz von besonderen, zwar schnell schaltenden, aber dafür sehr teuren Bauelementen kann bei der erfindungsgemäßen Vorrichtung verzichtet werden. Trotz der an sich relativ langen Schaltzeiten und notwendigen stabilen Signalvorhaltzeiten der in der erfindungsgemäßen Vorrichtung verwendeten Standard-Bauelemente (D-Flip-Flops und NAND-Gatter) können durch ein geschicktes Verschalten der Bauelemente auch geringe Verzögerungen zwischen zwei Pulssignalen zuverlässig und mit einer hohen Genauigkeit ermittelt werden. Ohne Probleme können sogar Verzögerungen ermittelt werden, die die genannten internen Schaltzeiten und notwendigen Vorhaltzeiten unterschreiten.

Vorzugsweise weisen die zweiten Mittel einen ersten Tiefpaßfilter zum Ermitteln des in dem invertierten Diagnosesignal enthaltenen Gleichanteils auf. Ebenso wird vorgeschlagen, daß die zweiten Mittel einen zweiten Tiefpaßfilter zum Ermitteln des in dem Diagnosesignal enthaltenen Gleichanteils aufweisen.

Schließlich ist es eine Aufgabe der vorliegenden Erfindung, einen Sensor der eingangs genannten Art dahingehend auszugestalten und weiterzubilden, daß die Laufzeit des ersten Pulssignals von dem einen Objekt zu dem anderen Objekt und wieder zurück, insbesondere die tatsächliche Verzögerung zwischen dem ausgesandten ersten Pulssignal und dem verzögerten zweiten Pulssignal, möglichst genau ermittelt werden kann.

Zur Lösung dieser Aufgabe schlägt die Erfindung ausgehend von dem Sensor der eingangs genannten Art vor, daß die fünften Mittel eine Vorrichtung nach einem der Ansprüche 15 bis 21 zum Messen der zeitlichen Verzögerung zwischen dem ersten Pulssignal und dem zweiten Pulssignal aufweisen.

Vorteilhafterweise weisen die ersten Mittel einen Pulswiederholgenerator zum Erzeugen eines periodischen Pulswiederholsignals und ein erstes Mono-Flop zum Auslösen des ersten Pulssignals von einer Flanke des Pulswiederholsignals auf. Das Mono-Flop wird insbesondere dann benötigt, wenn das erste Pulssignal als ein Radar-Signal ausgebildet ist. Im allgemeinen Fall kommt die Erfindung jedoch auch ohne Mono-Flop aus. Das Mono-Flop dient der einheitlichen Signalformung.

Ebenso weisen die dritten Mittel vorteilhafterweise einen Pulswiederholgenerator zum Erzeugen eines periodischen Pulswiederholsignals, ein Totzeitglied zum Verzögern des Pulswiederholsignals um eine variable Verzögerung und ein zweites Mono-Flop zum Auslösen des zweiten Pulssignals von einer Flanke des verzögerten Pulswiederholsignals auf. Sowohl das erste Pulssignal als auch das zweite Pulssignal werden vorzugsweise von ansteigenden Flanken des Pulswiederholsignals bzw. des verzögerten Pulswiederholsignals getriggert. Außerdem werden das erste Pulssignal und das zweite Pulssignal vorzugsweise von demselben Pulswiederholsignal getriggert, das von einem gemeinsamen Pulswiederholgenerator erzeugt wird.

Gemäß einer bevorzugten Ausführungsform weist der Sensor ein zweites D-Flip-Flop zum Erzeugen eines Steuersignals auf, an dessen Takteingang das invertierte Pulswiederholsignal und an dessen D-Eingang das invertierte Steuersignal anliegt. Dadurch kann das Steuersignal mit der halben Frequenz des ersten Pulssignals auf einfache Weise aus dem Pulswiederholsignal erzeugt werden. Bei dem D-Flip-Flop zum Erzeugen des Steuersignals handelt es sich um ein Standard-Bauelement, das einen besonders niedrigen Stückpreis aufweist.

Vorteilhafterweise weist der Sensor ein viertes NAND-Gatter zum Invertieren des Pulswiederholsignals auf. Auch bei dem NAND-Gatter handelt es sich um ein Standard-Bauelement, das einen besonders niedrigen Stückpreis aufweist. Zudem kann das vierte NAND-Gatter zusammen mit den anderen drei NAND-Gattern des Multiplexers als ein integrales Bauteil ausgeführt werden. Dadurch sind die Auswirkungen auf die elektrischen Eigenschaften der NAND-Gatter aufgrund von Temperaturänderungen in etwa gleich groß und können durch geeignetes Verschalten der NAND-Gatter auf einfache Weise kompensiert werden.

Zwei bevorzugte Ausführungsbeispiele der vorliegenden Erfindung werden nachfolgend anhand der Zeichnungen näher erläutert. Es zeigen:

Fig. 1    ein erstes Ausführungsbeispiel einer Schaltung einer erfindungsgemäßen Vorrichtung zum Messen der zeitlichen Verzögerung zwischen zwei periodischen Pulssignalen zum Einsatz in einem erfindungsgemäßen Sensor;

Fig. 2    ein zweites Ausführungsbeispiel einer Schaltung einer erfindungsgemäßen Vorrichtung zum Messen der zeitlichen Verzögerung zwischen zwei periodischen Pulssignalen zum Einsatz in einem erfindungsgemäßen Sensor;

Fig. 3    den Signalverlauf verschiedener Signale aus den Schaltungen aus den Fig. 1 und 2; und

Fig. 4    den Signalverlauf verschiedener Signale aus der Schaltung aus Fig. 2;

Zum Messen des Abstands zwischen zwei Objekten mit einem Sensor, der an einem der beiden Objekte angeordnet ist, werden üblicherweise Sensoren eingesetzt, die die Laufzeit eines ersten periodischen Pulssignals 2 von seiner Aussendung durch den Sensor über die Reflexion an dem anderen Objekt bis zu dem Empfang durch den Sensor bestimmen.

Aufgrund der relativ hohen Ausbreitungsgeschwindigkeiten der verwendeten Pulssignale, liegen die zu bestimmenden Laufzeiten der ersten Pulssignale 2 bei der Annahme eines maximalen Meßbereichs von wenigen Metern, insbesondere bei Pulsradar-Sonsoren, im Nanosekundenbereich. Diese äußerst kurzen Laufzeiten der ersten Pulssignale 2 können nicht direkt gemessen werden, indem beispielsweise ein Zeitgeber beim Aussenden des Signals mit START und beim Empfang des reflektierten Signals mit STOP gesetzt wird. Vielmehr finden zum Bestimmen der Pulslaufzeiten indirekte vergleichende Verfahren Anwendung.

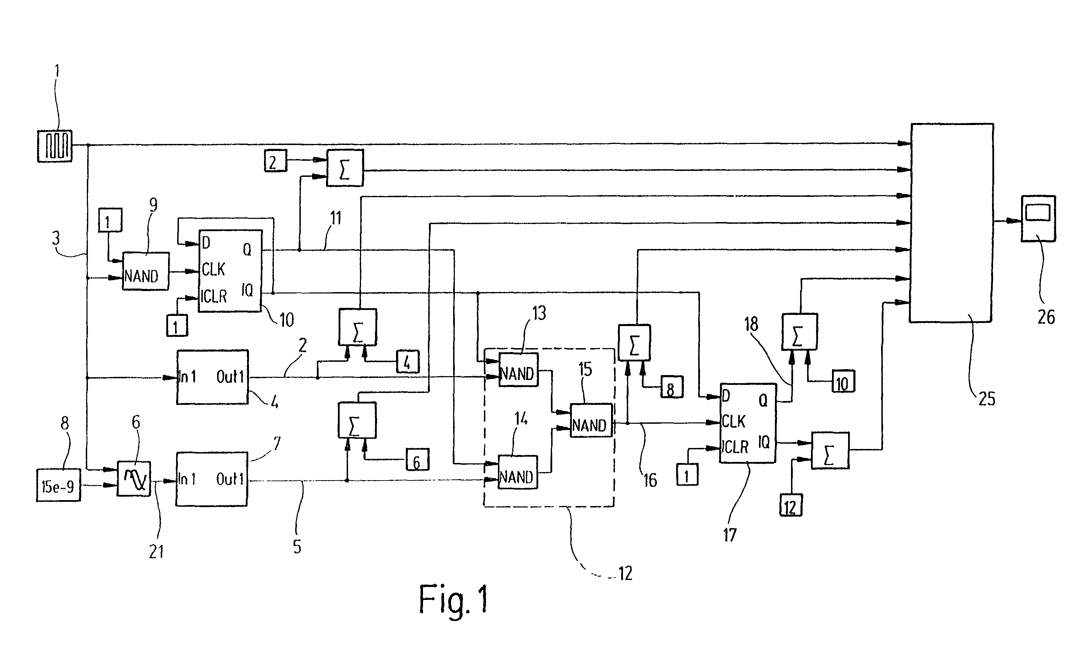

Bei dem vergleichenden Verfahren erzeugt ein Pulswiederholgenerator 1 des Sensors das erste periodische Pulssignal 2. Das erste Pulssignal 2 benötigt von seiner Aussendung durch den Sensor über die Reflexion an dem anderen Objekt bis zu dem Empfang durch den Sensor eine bestimmte Laufzeit. Zur Bestimmung dieser Laufzeit erzeugt der Sensor ein zweites periodisches Pulssignal 5, das die gleiche Frequenz wie das erste Pulssignal 2 aufweist und das durch ein sensorinternes variables Totzeitglied 6 um eine vorgegebene Verzögerung gegenüber dem ersten Pulssignal 2 verzögert ist. Die Ansteuerung des variablen Totzeitglieds 6 erfolgt dabei über eine relativ langsam variierende Sweepspannung 8. In der Schaltung aus Fig. 1 erfolgt die Ansteuerung des Totzeitglieds 6 über eine konstante Spannung, so daß die Verzögerung $15 \cdot 10^{-9}$ s = 15 ns beträgt.

Sowohl das empfangene erste Pulssignal als auch das verzögerte zweite Pulssignal 5 wird einem Mischer zugeführt, der genau dann ein maximales Ausgangssignal liefert, wenn die Laufzeit des empfangenen ersten Pulssignals gleich groß ist wie die durch das variable Totzeitglied 6 eingestellte Verzögerung des zweiten Pulssignals 5.

Die Messung der tatsächlich eingestellten Verzögerung erlaubt eine Überwachung der Sweepspannung 8 durch eine Steuereinheit (Mikrocontroller), so daß die richtigen Sweepspannungswerte ausgegeben werden können, um eine gewünschte interne Verzögerung zu erreichen. Die Überwachung der realen internen Verzögerung durch die erfindungsgemäße Vorrichtung erlaubt dabei die Kompensation evtl. auftretender Abweichungen der Ansteuercharakteristik des Totzeitglieds 6. Dann kann aus dem Wert der eingestellten Verzögerung die Laufzeit des ersten Pulssignals 2 bestimmt und aus der Laufzeit der Abstand zwischen den beiden Objekten ermittelt werden.

Für eine solche Regelung muß die zeitliche Verzögerung zwischen dem ausgesandten ersten Pulssignal 2 und dem verzögerten zweiten Pulssignal 5 ermittelt werden. Das erfolgt erfindungsgemäß dadurch, daß ein periodisches Diagnosesignal 18 mit der halben Frequenz des ersten Pulssignals 2 erzeugt wird. Das Tastverhältnis des Diagnosesignals 18 ist ein Maß für die zeitliche Verzögerung zwischen dem ersten Pulssignal 2 und dem zweiten Pulssignal 5. Die zeitliche Verzögerung zwischen dem ausgesandten ersten Pulssignal 2 und dem zweiten Pulssignal 5 wird dadurch bestimmt, daß das Tastverhältnis des Diagnosesignals 18 bestimmt wird.

Genauer gesagt arbeitet die Schaltung aus Fig. 1 folgendermaßen: Der Pulswiederholgenerator 1 löst die periodische Aussendung des ersten Pulssignals 2 aus. Der Pulswiederholgenerator 1 wird mit einer Frequenz von bspw. 16 MHz betrieben. Der Pulswiederholgenerator 1 erzeugt zunächst ein Pulswiederholsignal 3, das an ein erstes Monoflop 4 geleitet wird, in dem das erste Pulssignal 2 aus dem Pulswiederholsignal 3 erzeugt wird. Das erste Pulssignal 2 hat die gleiche Frequenz wie das Pulswiederholsignal 3. Die ansteigenden Flanken des Pulswiederholsignals 3 triggern die Pulse des ersten Pulssignals 2.

Der Pulswiederholgenerator 1 löst außerdem ein zweites Pulssignal 5 aus, das relativ zu dem ersten Pulssignal 2 zeitlich verzögert ist. Dazu wird das Pulswiederholsignal 3 über das variable Totzeitglied 6 um eine vorgebbare Verzögerung verzögert. Die Verzögerung des Totzeitglieds 6 erfolgt über eine relativ langsam variierbare Sweepspannung 8. In dem Ausführungsbeispiel aus Fig. 1 ist die Sweepspannung 8 auf den konstanten Wert eingestellt, der eine Verzögerung von 15 ns erzeugt. Das verzögerte Pulswiederholsignal 21 wird an ein zweites Monoflop 7 geleitet, in dem das zweite Pulssignal 5 erzeugt wird. Das zweite Pulssignal 5 hat die gleiche Frequenz wie das Pulswiederholsignal 3. Die ansteigenden Flanken des verzögerten Pulswiederholsignals 21 triggern die Pulse des zweiten Pulssignals 5.

Das Pulswiederholsignal 3 wird außerdem über ein NAND-Gatter 9 an den Takteingang CLK eines D-Flip-Flops 10 geleitet. Durch das NAND-Gatter 9 wird das Pulswiederholsignal 3 invertiert. Die Invertierung des Pulswiederholsignals 3 ist notwendig, da das D-Flip-Flop 10 mit der positiven Flanke des Pulswiederholsignals 3 taktet. Durch das D-Flip-Flop 10 wird aus dem Pulswiederholsignal 3 ein Rechteck-Steuersignal 11 mit der halben Frequenz des Pulswiedeholsignals 3 und damit auch mit der halben Frequenz des ersten Pulssignals 2 abgeleitet. Die Flanken des Steuersignals 11 werden durch die abfallenden Flanken des Pulswiederholsignals 3 getriggert.

Die Schaltung aus Fig. 1 weist außerdem einen Multiplexer 12 auf. Der Multiplexer 12 wird aus drei NAND-Gattern 13, 14, 15 gebildet. An die Eingänge des ersten NAND-Gatters 13 wird das invertierte Steuersignal 11 und das erste Pulssignal 2 geleitet. An den Eingängen des zweiten NAND-Gatters 14 liegt das Steuersignal 11 und das zweite Pulssignal 5 an. Die Ausgänge des ersten NAND-Gatters 13 und des zweiten NAND-Gatters 14 werden an die Eingänge des dritten NAND-Gatters 15 geleitet. Der Ausgang des dritten NAND-Gatters 15 bzw. der Ausgang des Multiplexers 12 wird dann an den Takteingang CLK eines weiteren D-Flip-Flops 17 geleitet. Wenn das Steuersignal 11 auf LOW liegt, dann wird das erste Pulssignal 2 an den Takteingang CLK des D-Flip-Flops 17 durchgeführt. Wenn das Steuersignal 11 dagegen auf HIGH liegt, dann wird das zweite Pulssignal 5 an den Takteingang CLK des D-Flip-Flops 17 durchgeführt.

Das D-Flip-Flop 17 wird durch jede zweite ansteigende Flanke des ersten Pulssignals 2 gesetzt und durch jede zweite ansteigende Flanke des zweiten Pulssignals 5 zurückgesetzt. Wenn das erste Pulssignal 2 und das zweite Pulssignal 5 keine zeitliche Verzögerung relativ zueinander besitzen, so schaltet der Ausgang Q des D-Flip-Flops 17 als Rechteck-Generator mit einem exakten Tastverhältnis von 50% zwischen HIGH und LOW. Die Periode des an dem Ausgang Q des D-Flip-Flops 17 anliegenden Diagnosesignals 18 entspricht dann der Periode des Steuersignals 11 und somit der halben Periode des ersten Pulssignals 2.

Wird nun, wie in dem Ausführungsbeispiel aus Fig. 1 dargestellt, eine Verzögerung von 15 ns an dem variablen Totzeitglied 6 eingestellt, so verschiebt sich das Tastverhältnis des Diagnosesignals 18 entsprechend. Die Zeit, die das Diagnosesignal 18 den Zustand HIGH aufweist, ergibt sich aus der halben Periodendauer des Diagnosesignals 18 zuzüglich dem Verhältnis der zeitlichen Verzögerung zu der Gesamtperiode. Die Gesamtperiode ist die doppelte Periode des ersten Pulssignals 2 und somit bekannt. Das Tastverhältnis x an dem Ausgang Q des D-Flip-Flops 17 berechnet sich also aus:

$$X_Q = 50\% + 0,5 \cdot 15ns \cdot 16MHz = 50\% + 12\% = 62\%.$$

Ebenso ergibt sich das Tastverhältnis an dem invertierten Ausgang |Q des zweiten D-Flip-Flops 17 aus:

$$x_{|Q} = 50\% - 0,5 \cdot 15ns \cdot 16MHz = 50\% - 12\% = 38\%.$$

Aus dem Tastverhältnis des Diagnosesignals 18 des D-Flipflops 17 kann somit die tatsächliche Verzögerung zwischen dem von dem Sensor ausgesandten ersten Pulssignal 2 und dem verzögerten zweiten Pulssignal 5 genau ermittelt werden.

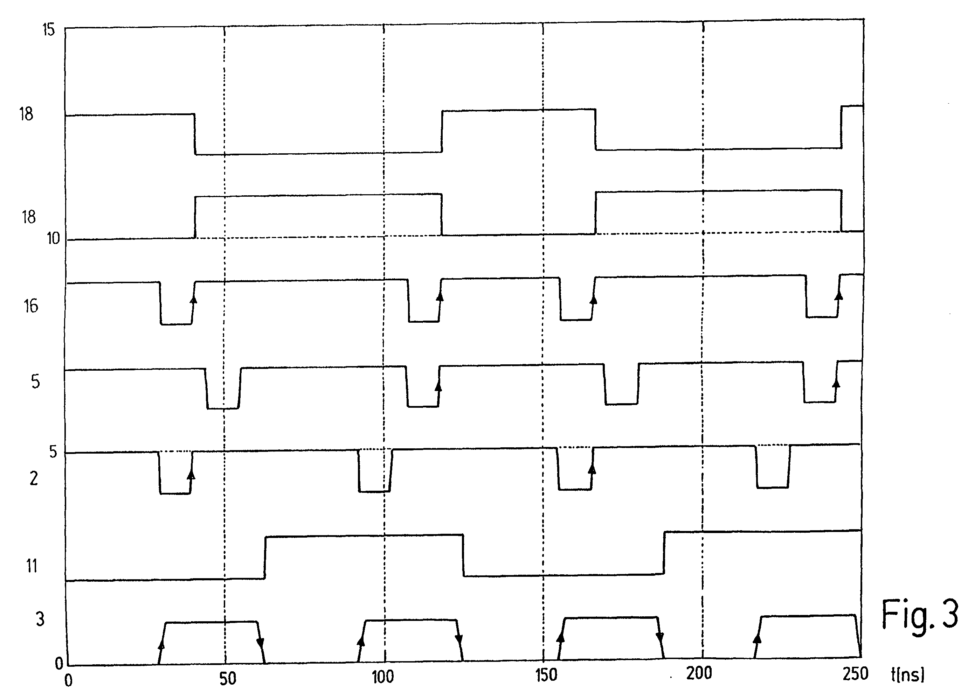

Das Pulswiederholsignal 3, das Steuersignal 11, das erste Pulssignal 2, das zweite Pulssignal 5, das Ausgangssignal 16 des Multiplexers 12, das Diagnosesignal 18 und das invertierte Diagnosesignal 18 werden an die Eingänge eines weiteren Multiplexers 25 angelegt. Dieser Multiplexer 25 dient nur dazu, in der Modellierung mehrere Kanäle auf einem ersten Oszilloskop 26 darzustellen. Zur Darstellung der Signalverläufe ist der Ausgang des Multiplexers 25 an das erste Oszilloskop 26 angeschlossen. Die Signalverläufe des Oszilloskops 26 sind in Fig. 3 dargestellt.

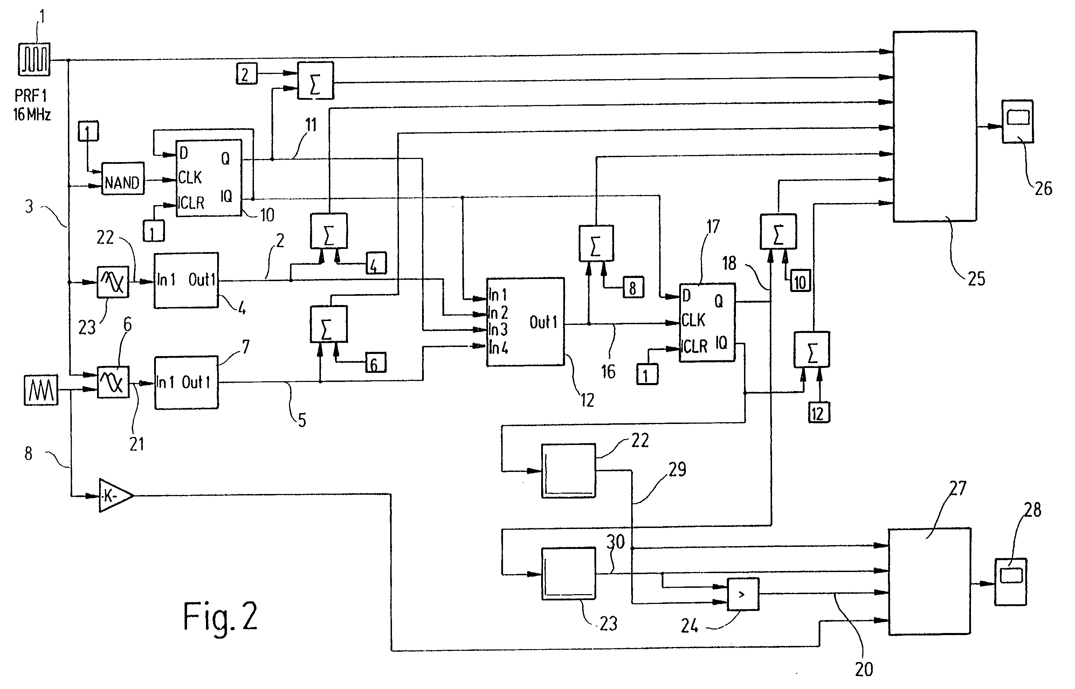

Das Tastverhältnis des Diagnosesignals 18 kann durch Ermittlung des Gleichanteils des Diagnosesignals 18 ermittelt werden. Der Gleichanteil des invertierten Diagnosesignals 18 wird mittels eines ersten Tiefpasses 22 (vgl. Fig. 2) ermittelt. Ebenso wird der Gleichanteil des Diagnosesignals 18 mittels eines zweiten Tiefpasses 23 ermittelt. Die Ausgänge der Tiefpässe 22 und 23 werden einem Vergleicher 24 zugeführt.

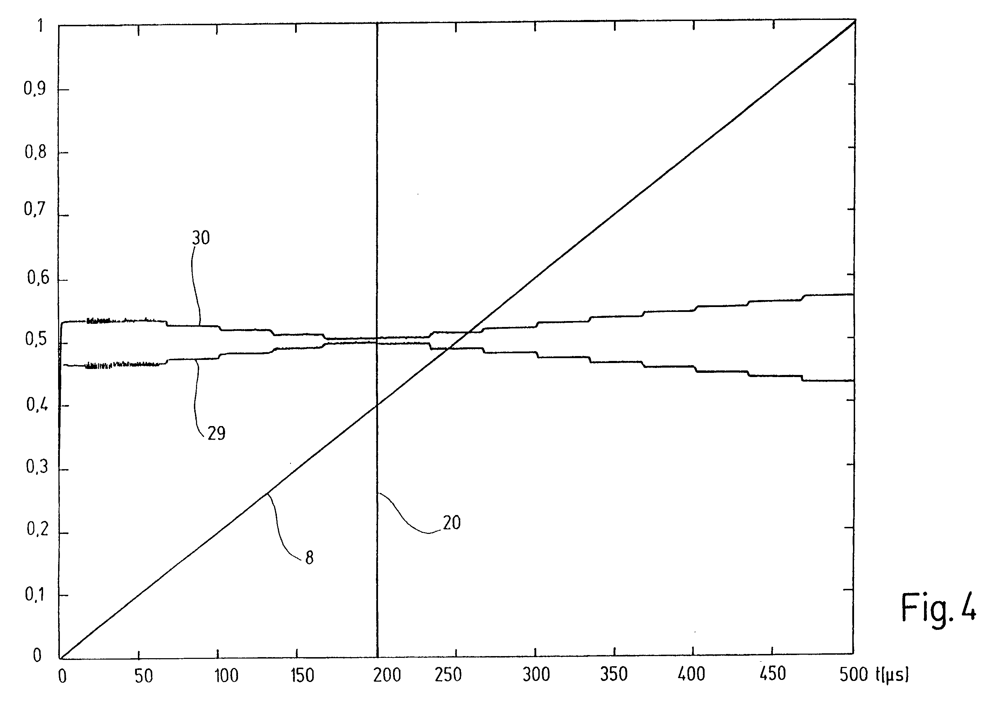

Das Ausgangssignal 29 des ersten Tiefpasses 22, das Ausgangssignal 30 des zweiten Tiefpasses 23, das Ausgangssignal 20 des Vergleichers 24 und die Sweepspannung 8 werden an die Eingänge eines weiteren Multiplexers 27 angelegt. Zur Darstellung der Signalverläufe ist der Ausgang des Multiplexers 27 an ein zweites Oszilloskop 28 angeschlossen. Die Signalverläufe des Oszilloskops 28 sind in Fig. 4 dargestellt.

In Fig. 4 ist zu erkennen, daß sich durch Variieren der Sweepspannung 8 auch das Tastverhältnis des Diagnosesignals 18 und des invertierten Diagnosesignals verändern. Gleichzeitig verändern sich auch die Gleichanteile des Diagnosesignals 18 und des invertierten Diagnosesignals 18 und damit auch die Ausgangssignale 29 und 30 der Tiefpässe 22 und 23. In Fig. 4 ist deutlich zu erkennen, daß der Verlauf des Ausgangssignals 20 des Vergleichers 24 zu dem Zeitpunkt von Null auf Eins hochschnellt, zu dem das Ausgangssignal 29 des ersten Tiefpasses 22 und das Ausgangssignal 30 des zweiten Tiefpasses 23 gleich groß sind, d. h. zu dem das Tastverhältnis des Diagnosesignals 18 50% beträgt und zu dem das zweite Pulssignal 5 relativ zu dem ersten Pulssignal 2 nicht verzögert ist.

Mit Hilfe der in den Fig. 1 und Fig. 2 dargestellten Schaltungen kann die tatsächliche Verzögerung zwischen dem ersten Pulssignal 2 und dem zweiten Pulssignal 5 besonders genau bestimmt werden, was eine besonders genaue Bestimmung der Laufzeit des ersten Pulssignals 2 von dem einen Objekt zu dem anderen Objekt und wieder zurück und damit eine besonders genaue Ermittlung des Abstands zwischen diesen beiden Objekten erlaubt. Außerdem gibt die erfindungsgemäße Vorrichtung an, wenn das Tastverhältnis des Diagnosesignals 18 genau 50% beträgt, also wenn die eingestellte Verzögerung Null ist. Dieser Punkt ist wichtig für die Kalibrierung der erfindungsgemäßen Vorrichtung.

Die in den Fig. 1 und Fig. 2 dargestellten Schaltungen weisen zum größten Teil preiswerte Standardbauelemente auf. Zum Messen geringer Abstände (z. B. weniger als 10 m) zwischen zwei Objekten mittels eines Pulssignals, d. h., dass zwischen zwei Pulstriggerflanken sehr kleine Zeitabstände bestehen, musste bisher auf besondere, schnellschaltende Bauelelemente zurückgegriffen werden, die jedoch sehr teuer sind. Bei den erfindungsgemäßen Schaltungen gem. der Fig. 1 und Fig. 2 wurden langsam schaltende Standard-Bauelemente (NAND-Gatter und D-Flipflops) vewendet. Die Standard-Bauelemente wurden in vorteilhafter Weise derart miteinander verschaltet, daß mit den Schaltungen trotz dieser Standard-Bauelemente auch kleine Zeitabstände zwischen zwei Pulstriggerflanken, die interne Schaltzeiten und Signalvorhaltzeiten der Standard-Bauelemente unterschreiten können, und damit auch geringe Abstände zwischen zwei Objekten gemessen werden können.

Darüber hinaus sind die vier verwendeten NAND-Gatter 9, 13, 14, 15 in einem Bauelement integriert. Dadurch ist der Drift aufgrund von Betriebstemperaturschwankungen in allen vier NAND-Gattern 9, 13, 14, 15 in etwa gleich groß. Die NAND-Gatter 9, 13, 14, 15 sind in vorteilhafter Weise derart in die Schaltungen aus Fig. 1 und Fig. 2 integriert, dass der Drift der einzelnen NAND-Gatter 9, 13, 14, 15 kompensiert wird und sich somit kaum bzw. gar nicht auf das Messergebnis auswirkt. Zudem ist der Signalpfad für das triggernde erste Pulssignal 2 und das triggernde zweite Pulssignal 5 bis auf die zweite getrennten NAND-Gatter 13, 14 im Multiplexer 12 identisch, so daß ein möglicher Drift der Elemente des identischen Pfades (NAND 15 und Flip-Flop 17) bei der vergleichenden Messung keine Rolle spielt. Da die getrennten NANDs 13, 14 monolytisch integriert sind, kompensiert sich ihr absoluter Temperaturdrift ebenfalls.

**Patentansprüche**

1.  Verfahren zum Messen der zeitlichen Verzögerung zwischen einem ersten periodischen Pulssignal (2) und einem zweiten periodischen Pulssignal (5), das die gleiche Frequenz aufweist wie das erste Pulssignal (2), **gekennzeichnet durch** die nachfolgenden Schritte:

    -   Erzeugen eines periodischen Diagnosesignals (18) mit der halben Frequenz des ersten Pulssignals (2), dessen Tastverhältnis ein Maß für die zeitliche Verzögerung zwischen dem ersten Pulssignal (2) und dem zweiten Pulssignal (5) ist,
    -   Bestimmen des Tastverhältnisses des Diagnosesignals (18), und
    -   Bestimmen der zeitlichen Verzögerung zwischen dem ersten Pulssignal (2) und dem zweiten Pulssignal (5) aus dem Tastverhältnis des Diagnosesignals (18).

2.  Verfahren nach Anspruch 1, **dadurch gekennzeichnet, daß** das Diagnosesignal (18) abwechselnd von einer Flanke des ersten Pulssignals (2) und von einer Flanke des zweiten Pulssignals (5) getriggert wird.

3.  Verfahren nach Anspruch 1 oder 2, **dadurch gekennzeichnet, daß** das Diagnosesignal (18) abwechselnd von einer ansteigenden Flanke des ersten Pulssignals (2) und von einer ansteigenden Flanke des zweiten Pulssignals (5) getriggert wird.

4.  Verfahren nach Anspruch 2 oder 3, **dadurch gekennzeichnet, daß**

    -   ein Steuersignal (11) mit der halben Frequenz des ersten Pulssignals (2) erzeugt wird,
    -   das invertierte Steuersignal (11) an einen ersten Steuer-Eingang eines Multiplexers (12) geführt wird,
    -   das erste Pulssignal (2) an einen ersten Signal-Eingang des Multiplexers (12) geführt wird,
    -   das Steuersignal (11) an einen zweiten Steuer-Eingang des Multiplexers (12) geführt wird,
    -   das zweite Pulssignal (5) an einen zweiten Signal-Eingang des Multiplexers (12) geführt wird,
    -   der Ausgang (16) des Multiplexers (12) an den Takteingang (CLK) eines ersten D-Flip-Flops (17) geführt wird,
    -   das invertierte Steuersignal (11) an den D-Eingang des ersten D-Flip-Flops (17) geführt wird, und

    -   an einem Ausgang (Q) des ersten D-Flip-Flops (17) das Diagnosesignal (18) anliegt.

5.  Verfahren nach einem der Ansprüche 1 bis 4, **dadurch gekennzeichnet, daß** zum Bestimmen des Tastverhältnisses des Diagnosesignals (18) der in dem Diagnosesignal (18) enthaltene Gleichanteil ermittelt wird.

6.  Verfahren nach Anspruch 5, **dadurch gekennzeichnet, daß** das invertierte Diagnosesignal (18) über einen ersten Tiefpaßfilter (22) geführt wird.

7.  Verfahren nach Anspruch 5 oder 6, **dadurch gekennzeichnet, daß** das Diagnosesignal (18) über einen zweiten Tiefpaßfilter (23) geführt wird.

8.  Verfahren nach einem der Ansprüche 1 bis 7, **dadurch gekennzeichnet, daß** das Tastverhältnis des Diagnosesignals (18) ohne eine zeitliche Verzögerung zwischen dem ersten Pulssignal (2) und dem zweiten Pulssignal (5) etwa 50% beträgt und daß sich das Tastverhältnis des Diagnosesignals (18) proportional zu der zeitlichen Verzögerung zwischen dem ersten Pulssignal (2) und dem zweiten Pulssignal (5) verändert.

9.  Verfahren zum Messen des Abstands zwischen zwei Objekten mittels eines Sensors, der an einem der Objekte angeordnet ist, wobei

    -   durch den Sensor ein erstes periodisches Pulssignal (2) ausgelöst und in Richtung auf das andere Objekt ausgesendet wird,
    -   das von dem anderen Objekt reflektierte erste Pulssignal (2), das um eine von dem Abstand der beiden Objekte abhängige Laufzeit verzögert ist, von dem Sensor empfangen wird,
    -   durch den Sensor ein um eine variable zeitliche Verzögerung verzögertes zweites periodisches Pulssignal (5) ausgelöst wird,
    -   die variable zeitliche Verzögerung des zweiten Pulssignals (5) variiert wird, und
    -   die variable zeitliche Verzögerung bestimmt wird, die gleich der Laufzeit des empfangenen reflektierten ersten Pulssignals (2) ist,

    **dadurch gekennzeichnet, daß** die eingestellte variable zeitliche Verzögerung durch Messen der zeitlichen Verzögerung zwischen dem ersten Pulssignal (2) und dem zweiten Pulssignal (5) mittels des Verfahrens nach einem der Ansprüche 1 bis 8 bestimmt wird.

10. Verfahren nach Anspruch 9, **dadurch gekennzeichnet, daß** durch einen Pulswiederholgenerator (1) des Sensors ein periodisches Pulswiederholsignal (3) erzeugt wird, und das erste Pulssignal (2) von einer Flanke des Pulswiederholsignals (3) ausgelöst wird.

11. Verfahren nach Anspruch 10, **dadurch gekennzeichnet, daß** das erste Pulssignal (2) von den ansteigenden Flanken des Pulswiederholsignals (3) ausgelöst wird.

12. Verfahren nach einem der Ansprüche 9 bis 11, **dadurch gekennzeichnet, daß** das zweite Pulssignal (5) von einer Flanke des um die variable zeitliche Verzögerung verzögerten Pulswiederholsignals (3) ausgelöst wird.

13. Verfahren nach Anspruch 12, **dadurch gekennzeichnet, daß** das zweite Pulssignal (5) von den ansteigenden Flanken des um die variable zeitliche Verzögerung verzögerten Pulswiederholsignals (3) ausgelöst wird.

14. Verfahren nach einem der Ansprüche 9 bis 13, **dadurch gekennzeichnet, daß** das invertierte Pulswiederholsignal (3) an den Takteingang (CLK) eines zweiten D-Flip-Flops (10) geführt wird, an einem Ausgang (Q) des zweiten D-Flip-Flops (10) ein Steuersignal (11) anliegt und an einem weitere Ausgang (|Q) des zweiten D-Flip-Flops (10) das invertierte Steuersignal (11) anliegt, das an den D-Eingang des zweiten D-Flip-Flops (10) geführt wird.

15. Vorrichtung zum Messen der zeitlichen Verzögerung zwischen einem ersten periodischen Pulssignal (2) und einem zweiten periodischen Pulssignal (5), das die gleiche Frequenz aufweist wie das erste Pulssignal (2), **gekennzeichnet durch**

   - sechste Mittel zum Erzeugen eines periodischen Diagnosesignals (18) mit der halben Frequenz des ersten Pulssignals (2), dessen Tastverhältnis ein Maß für die zeitliche Verzögerung zwischen dem ersten Pulssignal (2) und dem zweiten Pulssignal (5) ist,
   - siebte Mittel zum Bestimmen des Tastverhältnisses des Diagnosesignals (18), und
   - achte Mittel zum Bestimmen der zeitlichen Verzögerung zwischen dem ersten Pulssignal (2) und dem zweiten Pulssignal (5) aus dem Tastverhältnis des Diagnosesignals (18).

16. Vorrichtung nach Anspruch 15, **dadurch gekennzeichnet, daß** die sechsten Mittel derart ausgebildet sind, daß das Diagnosesignal (18) abwechselnd von einer Flanke des ersten Pulssignals (2) und von einer Flanke des zweiten Pulssignals (5) getriggert wird.

17. Vorrichtung nach Anspruch 16, **dadurch gekennzeichnet, daß** die sechsten Mittel derart ausgebildet sind, daß das Diagnosesignal (18) abwechselnd von einer ansteigenden Flanke des ersten Pulssignals (2) und von einer ansteigenden Flanke des zweiten Pulssignals (5) getriggert wird.

18. Vorrichtung nach Anspruch 16 oder 17, **dadurch gekennzeichnet, daß** die sechsten Mittel aufweisen:

   - Mittel zum Erzeugen eines Steuersignals (11) mit der halben Frequenz des ersten Pulssignals (2),
   - einen Multiplexer (12), an dessen erstem Eingang das invertierte Steuersignal (11) anliegt, an dessen zweitem Eingang das erste Pulssignal (2) anliegt, an dessen drittem Eingang das Steuersignal (11) anliegt und an dessen viertem Eingang das zweite Pulssignal (5) anliegt,
   - ein erstes D-Flip-Flop (17), an dessen Takteingang (CLK) der Ausgang (16) des Multiplexers (12) anliegt, an dessen D-Eingang das invertierte Steuersignal (11) anliegt und an dessen Ausgang (Q) das Diagnosesignal (18) anliegt.

19. Vorrichtung nach Anspruch 18, **dadurch gekennzeichnet, daß** der Multiplexer (12) drei NAND-Gatter (13, 14, 15) aufweist, wobei an einem ersten Eingang des ersten NAND-Gatters (13) das invertierte Steuersignal (11) und an einem zweiten Eingang des ersten NAND-Gatters (13) das erste Pulssignal (2) angliegt, wobei an einem ersten Eingang des zweiten NAND-Gatters (14) das Steuersignal (11) und an einem zweiten Eingang des zweiten NAND-Gatters (14) das zweite Pulssignal (5) anliegt, wobei an einem ersten Eingang des dritten NAND-Gatters (15) der Ausgang des ersten NAND-Gatters (13) und an einem zweiten Eingang des dritten NAND-Gatters (15) der Ausgang des zweiten NAND-Gatters (14) anliegt und wobei der Ausgang (16) des dritten NAND-Gatters (15) an dem Takteingang (CLK) des ersten D-Flip-Flops (17) anliegt.

20. Vorrichtung nach einem der Ansprüche 15 bis 19, **dadurch gekennzeichnet, daß** die siebten Mittel einen ersten Tiefpaßfilter (22) zum Ermitteln des in dem invertierten Diagnosesignal (18) enthaltenen Gleichanteils aufweisen.

21. Vorrichtung nach einem der Ansprüche 15 bis 20, **dadurch gekennzeichnet, daß** die siebten Mittel einen zweiten Tiefpaßfilter (23) zum Ermitteln des in dem Diagnosesignal (18) enthaltenen Gleichanteils aufweisen.

22. Sensor zum Messen des Abstands zwischen zwei Objekten, wobei der Sensor an einem der Objekte angeordnet ist und aufweist:

- erste Mittel zum Auslösen und zum Aussenden eines ersten periodischen Pulssignals (2) in Richtung auf das andere Objekt,
- zweite Mittel zum Empfangen des von dem anderen Objekt reflektierten ersten Pulssignals (2), das um eine von dem Abstand der beiden Objekte abhängige Laufzeit verzögert ist,
- dritte Mittel zum Auslösen eines um eine variable zeitliche Verzögerung verzögerten zweiten periodischen Pulssignals (5),
- vierte Mittel zum Variieren der variablen zeitlichen Verzögerung des zweiten Pulssignals (5), und
- fünfte Mittel zum Bestimmen der variablen zeitlichen Verzögerung, bei der die Verzögerung gleich der Laufzeit des empfangenen reflektierten ersten Pulssignals (2) ist,

**dadurch gekennzeichnet, daß** die fünften Mittel eine Vorrichtung nach einem der Ansprüche 15 bis 21 zum Messen der zeitlichen Verzögerung zwischen dem ersten Pulssignal (2) und dem zweiten Pulssignal (5) aufweisen.

23. Sensor nach Anspruch 22, **dadurch gekennzeichnet, daß** die ersten Mittel einen Pulswiederholgenerator (1) zum Erzeugen eines periodischen Pulswiederholsignals (3) und ein erstes Mono-Flop (4) zum Auslösen des ersten Pulssignals (2) von einer Flanke des Pulswiederholsignals (3) aufweisen.

24. Sensor nach Anspruch 22 oder 23, **dadurch gekennzeichnet, daß** die dritten Mittel einen Pulswiederholgenerator (1) zum Erzeugen eines periodischen Pulswiederholsignals (3), ein Totzeitglied (6) zum Verzögern des Pulswiederholsignals (3) um eine variable zeitliche Verzögerung und ein zweites Mono-Flop (7) zum Auslösen des zweiten Pulssignals (5) von einer Flanke des verzögerten Pulswiederholsignals (3) aufweisen.

25. Sensor nach einem der Ansprüche 22 bis 24, **dadurch gekennzeichnet, daß** der Sensor ein zweites D-Flip-Flop (10) zum Erzeugen eines Steuersignals (11) aufweist, an dessen Takteingang (CLK) das invertierte Pulswiederholsignal (3) und an dessen D-Eingang das invertierte Steuersignal (11) anliegt.

26. Sensor nach Anspruch 25, **dadurch gekennzeichnet, daß** der Sensor ein viertes NAND-Gatter (9) zum Invertieren des Pulswiederholsignals (3) aufweist.

**Claims**

1. Method for measuring the time delay between a first periodic pulse signal (2) and a second periodic pulse signal (5) having the same frequency as the first pulse signal (2), **characterized by** the following steps:

- production of a periodic diagnostic signal (18) having half the frequency of the first pulse signal (2), whose sampling ratio is a measure of the time delay between the first pulse signal (2) and the second pulse signal (5),
- determination of the sampling ratio of the diagnostic signal (18), and
- determination of the time delay between the first pulse signal (2) and the second pulse signal (5) from the sampling ratio of the diagnostic signal (18).

2. Method according to claim 1, **characterized in that** the diagnostic signal (18) is alternately triggered from a side of the first pulse signal (2) and from a side of the second pulse signal (5).

3. Method according to claim 1 or 2, **characterized in that** the diagnostic signal (18) is alternately triggered from a rising side of the first pulse signal (2) and from a rising side of the second pulse signal (5).

4. Method in accordance with claim 2 or 3, **characterized in that**,

- a control signal (11) is produced with half the frequency of the first pulse signal (2),
- the inverted control signal (11) is passed to a first control input of a multiplexer (12),
- the first pulse signal (2) is passed to a first signal input of the multiplexer (12),
- the control signal (11) is passed to a second control input of the multiplexer (12),
- the second pulse signal (5) is passed to a second signal input of the multiplexer (12),
- the output (16) of the multiplexer (12) is passed to the clock input (CLK) of a first D flip-flop (17),
- the inverted control signal (11) is passed to the D input of the first D flip-flop (17), and
- the diagnostic signal (18) is available at the output (Q) of the first D flip-flop (17).

5. Method according to any one of the claims 1 to 4, **characterized in that** the equal fraction portion contained in the diagnostic signal (18) is determined for extraction of the sampling ratio of the diagnostic signal (18).

6. Method according to claim 5, **characterized in that** the inverted diagnostic signal (18) is passed to a first low pass filter (22).

7. Method according to claim 5 or 6, **characterized in**

**that** the diagnostic signal (18) is passed to a second low pass filter (23).

8. Method according to any one of the claims 1 to 7, **characterized in that** the sampling ratio of the diagnostic signal (18) assumes values of approximately 50% when there is no time delay between the first pulse signal (2) and the second pulse signal (5) and the sampling ratio of the diagnostic signal (18) changes in proportion to the time delay between the first pulse signal (2) and the second pulse signal (5).

9. Method for measuring the distance between two objects using a sensor disposed on one of the objects, wherein

   - the sensor triggers transmission of a first periodic pulse signal (2) towards the other object,
   - the first pulse signal (2), reflected from the other object and delayed by a propagation time dependent on the separation between the two objects, is received by the sensor,
   - the sensor triggers a second periodic pulse signal (5) which is delayed by a variable time delay,
   - the variable time delay of the second pulse signal (5) is varied, and
   - the variable time delay is determined which is equal to the propagation time of the received reflected first pulse signal (2),

   **characterized in that** the adjusted variable time delay is determined by measurement of the time delay between the first pulse signal (2) and the second pulse signal (5) using the method according to one of the claims 1 through 8.

10. Method of claim 9, **characterized in that** a periodic repetitive pulse signal (3) is produced by a sensor repetitive pulse generator (1) and the first pulse signal (2) is triggered from a side of the repetitive pulse signal (3).

11. Method according to claim 10, **characterized in that** the first pulse signal (2) is triggered from the rising side of the repetitive pulse signal (3).

12. Method according to any one of the claims 9 to 11, **characterized in that** the second pulse signal (5) is triggered from a side of the repetitive pulse signal (3) delayed by the variable time delay.

13. Method according to claim 12, **characterized in that** the second pulse signal (5) is triggered from the rising side of the repetitive pulse signal (3) delayed by the variable time delay.

14. Method according to any one of the claims 9 to 13, **characterized in that** the inverted repetitive pulse signal (3) is passed to the clock input (CLK) of a second D flip-flop (10) and a control signal (11) is present on the output (Q) of the second D flip-flop (10) and the inverted control signal (11) is present on an additional output (Q) of the second D flip-flop (10) which is passed to the D input of the second D flip-flop (10).

15. Device for measuring the time delay between a first periodic pulse signal (2) and a second periodic pulse signal (5) having the same frequency as the first pulse signal (2), **characterized by**

   - 6th means for producing a periodic diagnostic signal (18) having half the frequency of the first pulse signal (2) whose sampling ratio is a measure for the time delay between the first pulse signal (2) and the second pulse signal (5),
   - 7th means for determining the sampling ratio of the diagnostic signal (18) and
   - 8th means for determining the time delay between the first pulse signal (2) and the second pulse signal (5) from the sampling ratio of the diagnostic signal (18).

16. Device according to claim 15, **characterized in that** the 6th means are configured in such a fashion that a diagnostic signal (18) is alternately triggered from a side of a first pulse signal (2) and from a side of a second pulse signal (5).

17. Device according to claim 16, **characterized in that** the 6th means are configured in such a fashion that the diagnostic signal (18) is alternately triggered from a rising side of a first pulse signal (2) and from a rising side of a second pulse signal (5).

18. Device according to claim 16 or 17, **characterized in that**, the 6th means have

   - means for producing a control signal (11) having half the frequency of the first pulse signal (2),
   - a multiplexer (12) having the inverted control signal (11) applied to a first input thereof and the first pulse signal (2) applied to its second input, wherein the control signal (11) is applied to its third input and the second pulse signal (5) is applied to its fourth input,
   - a first D flip-flop (17) to whose clock input (CLK) the output (16) of the multiplexer (12) is applied and whose D input has the inverted control signal (11), wherein the diagnostic signal (18) is available at its output (Q).

19. Device of claim 18, **characterized in that** the multiplexer (12) comprises three NAND gates (13, 14, 15), wherein the inverted control signal (11) is applied to a first input of the first NAND gate (13) and the first pulse signal (2) is applied to a second input of the first NAND gate (13), wherein the control signal (11) is applied to a first input of the second NAND gate (14) and the second pulse signal (5) is applied to a second input of the second NAND gate (14), wherein a first input of the third NAND gate (15) has the output of the first NAND gate (13) and a second input of the third NAND gate (15) has the output of the second NAND gate (14), wherein the output (16) of a third NAND gate (15) is applied to the clock input (CLK) of the first D flip-flop (17).

20. Device according to any one of the claims 15 to 19, **characterized in that** the 7th means comprise a first low pass filter (22) for determining the equal fraction portions contained in the inverted diagnostic signal (18).

21. Device according to any one of the claims 15 to 20, **characterized in that** the 7th means comprise a second low pass filter (23) for determining an equal fraction portion contained in the diagnostic signal (18).

22. Sensor for measuring the distance between two objects, wherein the sensor is disposed on one of the objects and has

    - first means for triggering and for transmitting a first periodic pulse signal (2) in the direction towards the other object,
    - second means for receiving the first pulse signal (2) reflected from the other object which is delayed by the propagation time depending on the separation between the two objects,
    - third means for triggering a second periodic pulse signal (5) which is delayed by a variable time delay,
    - fourth means for varying the variable time delay of the second pulse signal (5) and
    - fifth means for determining the variable time delay, which is equal to the propagation time of the received reflected first pulse signal (2),

    **characterized in that** the fifth means comprise a device according to any one of the claims 15 to 21 for measuring the time delay between the first pulse signal (2) and the second pulse signal (5).

23. Sensor according to claim 22, **characterized in that** the first means comprise a repetitive pulse generator (1) for producing a periodic repetitive pulse signal (3) and a first mono-flop (4) for triggering the first pulse signal (2) from a side of the repetitive pulse signal (3).

24. Sensor according to claim 22 or 23, **characterized in that** the third means comprise a repetitive pulse generator (1) for producing a periodic repetitive pulse signal (3), a dead time component (6) for delaying the repetitive pulse signal (3) by a variable time delay and a second mono-flop (7) for triggering the second pulse signal (5) from a side of the delayed repetitive pulse signal (3).

25. Sensor according to any one of the claims 22 to 24, **characterized in that** the sensor comprises a second D flip-flop (10) for producing a control signal (11), on the clock input (CLK) of which the inverted repetitive pulse signal (3) is applied and on whose D input the inverted control signal (11) is present.

26. Sensor according to claim 25, **characterized in that** the sensor comprises a fourth NAND gate (9) for inverting the repetitive pulse signal (3).

**Revendications**

1. Procédé pour mesurer le retard dans le temps entre un premier signal d'impulsion (2) périodique et un second signal d'impulsion (5) périodique, qui présente la même fréquence que le premier signal d'impulsion (2), **caractérisé par** les étapes suivantes :

    - génération d'un signal de diagnostic (18) périodique avec la demi-fréquence du premier signal d'impulsion (2), dont le taux d'impulsions est une référence pour le retard dans le temps entre le premier signal d'impulsion (2) et le second signal d'impulsion (5),
    - calcul du taux d'impulsions du signal de diagnostic (18), et
    - calcul du retard dans le temps entre le premier signal d'impulsion (2) et le second signal d'impulsion (5) à partir du taux d'impulsions du signal de diagnostic (18).

2. Procédé selon la revendication 1, **caractérisé en ce que** le signal de diagnostic (18) est déclenché alternativement par un flanc du premier signal d'impulsion (2) et par un flanc du second signal d'impulsion (5).

3. Procédé selon la revendication 1 ou 2, **caractérisé en ce que** le signal de diagnostic (18) est déclenché alternativement par un flanc croissant du premier signal d'impulsion (2) et par un flanc croissant du second signal d'impulsion (5).

4. Procédé selon la revendication 2 ou 3, **caractérisé en ce que**

- un signal de commande (11) est généré avec la demi-fréquence du premier signal d'impulsion (2),
- le signal de commande (11) inversé est guidé sur une première entrée de commande d'un multiplexeur (12),
- le premier signal d'impulsion (2) est guidé sur une première entrée de signal du multiplexeur (12),
- le signal de commande (11) est guidé sur une seconde entrée de commande du multiplexeur (12),
- le second signal d'impulsion (5) est guidé sur une seconde entrée de signal du multiplexeur (12),
- la sortie (16) du multiplexeur (12) est guidée sur l'entrée de rythme (CLK) d'un premier flip-flop D (17),
- le signal de commande (11) inversé est guidé sur l'entrée D du premier flip-flop D (17), et
- le signal de diagnostic (18) s'applique sur une sortie (Q) du premier flip-flop D (17).

5. Procédé selon l'une quelconque des revendications 1 à 4, **caractérisé en ce que** la partie identique contenue dans le signal de diagnostic (18) est calculée pour la détermination du taux d'impulsions du signal de diagnostic (18).

6. Procédé selon la revendication 5, **caractérisé en ce que** le signal de diagnostic (18) inversé est guidé au moyen d'un premier filtre passe-bas (22).

7. Procédé selon la revendication 5 ou 6, **caractérisé en ce que** le signal de diagnostic (18) est guidé au moyen d'un second filtre passe-bas (23).

8. Procédé selon l'une quelconque des revendications 1 à 7, **caractérisé en ce que** le taux d'impulsions du signal de diagnostic (18) sans un retard dans le temps entre le premier signal d'impulsion (2) et le second signal d'impulsion (5) est d'environ 50 % et le taux d'impulsions du signal de diagnostic (18) varie de façon proportionnelle au retard dans le temps entre le premier signal d'impulsion (2) et le second signal d'impulsion (5).

9. Procédé pour mesurer un intervalle entre deux objets d'un capteur qui est disposé sur l'un des objets,

- un premier signal d'impulsion (2) périodique étant déclenché par le capteur et étant envoyé en direction de l'autre objet,
- le premier signal d'impulsion (2) réfléchi par l'autre objet, qui est retardé d'un temps de parcours dépendant de l'intervalle des deux objets, est reçu par le capteur,
- un second signal d'impulsion (5) périodique retardé d'une temporisation variable est déclenché,
- le retard dans le temps variable du second signal d'impulsion (5) est modifié, et
- on détermine le retard dans le temps variable qui est égal au temps de parcours du premier cylindre d'impulsion (2) réfléchi reçu,

**caractérisé en ce que** le retard dans le temps variable et réglé est déterminé par la mesure du retard dans le temps entre le premier signal d'impulsion (2) et le second signal d'impulsion (5) au moyen du procédé selon l'une quelconque des revendications 1 à 8.

10. Procédé selon la revendication 9, **caractérisé en ce qu'**un signal périodique de répétition d'impulsion (3) est généré par un générateur de répétition d'impulsion (1) et le premier signal d'impulsion (2) est déclenché par un flanc du signal de répétition d'impulsion (3).

11. Procédé selon la revendication 10, **caractérisé en ce que** le premier signal d'impulsion (2) est déclenché par les flancs croissants du signal de répétition d'impulsion (3).

12. Procédé selon l'une quelconque des revendications 9 à 11, **caractérisé en ce que** le second signal d'impulsion (5) est déclenché par un flanc du signal de répétition d'impulsion (3) retardé de la temporisation variable.

13. Procédé selon la revendication 12, **caractérisé en ce que** le second signal d'impulsion (5) est déclenché par les flancs croissants du signal de répétition d'impulsion (3) retardé de la temporisation variable.

14. Procédé selon l'une quelconque des revendications 9 à 13, **caractérisé en ce que** le signal inversé de répétition d'impulsion (3) est guidé sur l'entrée de rythme (CLK) d'un second flip-flop D (10), un signal de commande (11) est appliqué sur une sortie (Q) du second flip-flop D (10) et le signal de commande (11) inversé, qui est guidé sur l'entrée D du second flip-flop D (10), est appliqué sur une autre sortie (1Q) du second flip-flop D (10).

15. Dispositif pour mesurer le retard dans le temps entre un premier signal d'impulsion (2) périodique et un second signal d'impulsion (5) périodique, qui présente la même fréquence que le premier signal d'impulsion (2), **caractérisé par**

- des sixièmes moyens pour générer un signal de diagnostic (18) périodique présentant la demi-fréquence du premier signal d'impulsion (2), dont le taux d'impulsions est une référence pour le retard dans le temps entre le premier signal d'impulsion (2) et le second signal d'impulsion (5),

- des septièmes moyens pour la détermination du taux d'impulsions du signal de diagnostic (18), et
- des huitièmes moyens pour la détermination du retard dans le temps entre le premier signal d'impulsion (2) et le second signal d'impulsion (5) à partir du taux d'impulsions du signal de diagnostic (18).

**16.** Dispositif selon la revendication 15, **caractérisé en ce que** les sixièmes moyens sont conçus de telle sorte que le signal de diagnostic (18) est déclenché alternativement par un flanc du premier signal d'impulsion (2) et par un flanc du second signal d'impulsion (5).

**17.** Dispositif selon la revendication 16, **caractérisé en ce que** les sixièmes moyens sont conçus de telle sorte que le signal de diagnostic (18) est déclenché alternativement par un flanc croissant du premier signal d'impulsion (2) et par un flanc décroissant du second signal d'impulsion (5).

**18.** Dispositif selon la revendication 16 ou 17, **caractérisé en ce que** les sixièmes moyens présentent :

- des moyens pour générer un signal de commande (11) avec la demi-fréquence du premier signal d'impulsion (2),
- un multiplexeur (12), à la première sortie duquel s'applique le signal de commande (11) inversé, à la seconde entrée duquel s'applique le premier signal d'impulsion (2), à la troisième entrée duquel s'applique le signal de commande (11) et à la quatrième entrée duquel s'applique le second signal d'impulsion (5),
- un premier flip-flop D (17), à l'entrée de rythme (CLK) duquel s'applique la sortie (16) du multiplexeur (12), à l'entrée duquel s'applique le signal de commande (11) inversé et à la sortie (Q) duquel s'applique le signal de diagnostic (18).

**19.** Dispositif selon la revendication 18, **caractérisé en ce que** le multiplexeur (12) présente trois portes NON-ET (13, 14, 15), le signal de commande (11) inversé s'appliquant sur une première entrée de la première porte NON-ET (13) et le premier signal d'impulsion (2) s'appliquant sur une seconde entrée de la première porte NON-ET (13), le signal de commande s'appliquant sur une première entrée de la seconde porte NON-ET (14) et le second signal d'impulsion (5) s'appliquant sur une seconde entrée de la seconde porte NON-ET (14), la sortie de la première porte NON-ET (13) s'appliquant sur une première entrée de la troisième porte NON-ET (15) et la sortie de la seconde porte NON-ET (14) s'appliquant sur une seconde entrée de la troisième porte NON-ET (15) et la sortie (16) de la troisième porte NON-ET (15) s'appliquant sur l'entrée de rythme (CLK) du premier flip-flop (17).

**20.** Dispositif selon l'une quelconque des revendications 15 à 19, **caractérisé en ce que** les septièmes moyens présentent un premier filtre passe-bas (22) pour le calcul de la partie identique contenue dans le signal de diagnostic (18) inversé.

**21.** Dispositif selon l'une quelconque des revendications 15 à 20, **caractérisé en ce que** les septièmes moyens présentent un second filtre passe-bas (23) pour la détermination de la partie identique incluse dans le signal de diagnostic (18).

**22.** Capteur pour la mesure de l'intervalle entre deux objets, le capteur étant disposé sur l'un des objets et présentant :

- des premiers moyens pour le déclenchement et pour l'émission d'un premier signal d'impulsion (2) périodique en direction de l'autre objet,
- des seconds moyens pour la réception du premier signal d'impulsion (2) réfléchi par l'autre objet, qui est retardé d'un temps de parcours dépendant de l'intervalle des deux objets,
- des troisièmes moyens pour le déclenchement d'un second signal d'impulsion (5) retardé d'une temporisation variable,
- des quatrièmes moyens pour la variation du retard dans le temps variable du second signal d'impulsion (5), et
- des cinquièmes moyens pour la détermination du retard dans le temps variable, pour lequel la temporisation est égale au temps de parcours du premier signal d'impulsion (2) réfléchi et reçu,

**caractérisé en ce que** les cinquièmes moyens présentent un dispositif selon l'une quelconque des revendications 15 à 21 pour la mesure du retard dans le temps entre le premier signal d'impulsion (2) et le second signal d'impulsion (5).

**23.** Capteur selon la revendication 22, **caractérisé en ce que** les premiers moyens présentent un générateur de répétition d'impulsion (1) pour la génération d'un signal périodique de répétition d'impulsion (3) et un premier mono-flop (4) pour le déclenchement du premier signal d'impulsion (2) par un flanc du signal de répétition d'impulsion (3).

**24.** Capteur selon la revendication 22 ou 23, **caractérisé en ce que** les troisièmes moyens présentent un générateur de répétition d'impulsion (1) pour la génération d'un signal périodique de répétition d'impulsion (3), un élément de temps mort (6) pour la temporisation du signal de répétition d'impulsion (3) d'un retard dans le temps variable et un second mono-flop (7) pour le déclenchement du second signal d'impulsion (5) par un flanc du signal retardé de répétition d'impulsion (3).

25. Capteur selon l'une quelconque des revendications 22 à 24, **caractérisé en ce que** le capteur présente un second flip-flop D (10) pour la génération d'un signal de commande (11), sur l'entrée de rythme duquel (CLK) s'applique le signal inversé de répétition d'impulsion (3) et sur l'entrée D duquel s'applique le signal inversé de commande (11).

26. Capteur selon la revendication 25, **caractérisé en ce que** le capteur présente une quatrième porte NON-ET (9) pour l'inversion du signal de répétition d'impulsion (3).

NAND

D Q
CLK
ICLR IQ

In1 Out1

15e-9

In1 Out1

Σ

Σ

Σ

NAND

NAND

NAND

Σ

D Q
CLK
ICLR IQ

Σ

Σ

Fig. 1

EP 1 014 580 B1

Fig. 2

EP 1 014 580 B1

Fig. 3

Fig. 4

EP 1 014 580 B1